# EUROPEAN PATENT APPLICATION

(11) **EP 2 571 339 A2**
(43) Date of publication of application: **20.03.2013**
(21) Application number: 12183055.8
(22) Date of filing: 05.09.2012
(51) Int. Cl.: H05K 1/18, H04M 1/02, H05K 3/32

(54) **Thin electronic device comprising a conductive member**

(30) Priority: 14.09.2011 JP 2011201100
(71) Applicant: FUJITSU LIMITED, Kawasaki-shi, Kanagawa 211-8588 (JP)
(72) Inventor: SAKURAI, Tomonori, Kawasaki-shi, Kanagawa 211-8588 (JP); KOBAYASHI, Chikara, Hyogo, Hyogo 673-1447 (JP); MATSUDA, Hiroaki, Kawasaki-shi, Kanagawa 211-8588 (JP); YADA, Haruyoshi, Kawasaki-shi, Kanagawa 211-8588 (JP); HARADA, Kurumi, Kawasaki-shi, Kanagawa 211-8588 (JP); ARAKI, Tatsuhito, Kawasaki-shi, Kanagawa 211-8588 (JP)
(74) Representative: Lewin, David Nicholas

(57) **Abstract**

An electronic device (100) includes a printed circuit board (250) that a substrate contact part (250a) acting as a point of contact with another component (262) is formed on a board surface thereof, a conductive member (264) that has a first contact portion (264a) in contact with the substrate contact part, a plate-like extending portion (264b) extending from the first contact portion to the outside of the printed circuit board, and a second contact portion (264e) formed on a plate surface of the extending portion on the outside of the printed circuit board, and an electrical component that includes a component contact part (2624) in contact with the second contact portion and a body part (2622) on which the component contact part is formed, and is placed so that the component contact part or at least a part of the body part is opposed to an end face (250b) of the printed circuit board.

## Description

### FIELD

The embodiment discussed herein is related to an electronic device.

### BACKGROUND

An electronic device, such as a cellular phone, is equipped with various electrical components, such as a vibrator, a speaker, and a receiver. These electrical components transmit or receive an electrical signal with another component through a wiring pattern of a printed circuit board mounted on the electronic device.

For the transmission and receipt of an electrical signal, a contact point part for connection with an electrical component is formed on the printed circuit board, and a contact part for connection with the contact point part is formed on the body of the electrical component. Then, the contact point part of the printed circuit board and the contact part of the electrical component are electrically connected, for example, via a ground spring or a flexible conductive member (MAYFIT). Furthermore, the contact point part of the printed circuit board and the contact part of the electrical component can be directly connected without another member.

In related technologies, it is known that a contact point part formed on a printed circuit board and the metallic body of a vibrator installed in the position opposed to the board surface of the printed circuit board are electrically connected via a shield case and a contact which are formed of a conductive material.
Patent document 1: Japanese Laid-open Patent Publication No. 2000-49915

However, the related technologies have not considered making an electronic device having a printed circuit board and electrical components thinner.

Let's think of, for example, a case of connecting a contact part of an electrical component to a contact point part of a printed circuit board via a ground spring or a flexible conductive member. In this case, the electrical component is present in the position opposed to the board surface of the printed circuit board. Therefore, the sum of at least the board thickness of the printed circuit board, the thickness of the ground spring or flexible conductive member, the thickness of the contact part of the electrical component, and the body thickness of the electrical component is the overall thickness.

Even if the contact part of the electrical component is directly connected to the contact point part of the printed circuit board, the electrical component is still present in the position opposed to the board surface of the printed circuit board. Therefore, the sum of at least the board thickness of the printed circuit board, the thickness of the contact part of the electrical component, and the body thickness of the electrical component is the overall thickness. As a result, the total thickness of the printed circuit board and the electrical component may hinder an electronic device from being made thinner.

Accordingly, it is an object in one aspect of an embodiment of the invention to provide a thin electronic device having a printed circuit board and electrical components.

### SUMMARY

According to an aspect of the embodiments, an electronic device includes: a printed circuit board that a substrate contact part acting as a point of contact with another component is formed on a board surface thereof; a conductive member that has a first contact portion in contact with the substrate contact part, a plate-like extending portion extending from the first contact portion to the outside of external form of the printed circuit board along the board surface of the printed circuit board, and a second contact portion formed on a plate surface of the extending portion on the outside of the external form of the printed circuit board; and an electrical component that includes a component contact part in contact with the second contact portion and a body part on which the component contact part is formed, and is placed so that the component contact part or at least a part of the body part is opposed to an end face of the printed circuit board.

### BRIEF DESCRIPTION OF DRAWINGS

FIG. 1A is a front view of a cellular phone when it is in an open state;
FIG. 1B is a side view of the cellular phone when it is in the open state;
FIG. 2A is a front view of the cellular phone when it is in a folded state;
FIG. 2B is a side view of the cellular phone when it is in the folded state;
FIG. 3 is an exploded perspective view of a display-side module;
FIG. 4 is an exploded perspective view of an operation-side module;
FIG. 5 is a perspective view of a vibrator;
FIG. 6 is a cross-sectional view of the cellular phone along a line A-A illustrated in FIG. 1A;
FIG. 7 is an enlarged view of the contact structure of the vibrator and an operation-side front substrate;
FIG. 8 is a perspective view of a speaker;
FIG. 9 is a cross-sectional view of the cellular phone along a line B-B illustrated in FIG. 1A;
FIG. 10 is an enlarged view of the contact structure of the speaker and an operation-side rear substrate;
FIG. 11 is a perspective view of a receiver;
FIG. 12 is a cross-sectional view of the cellular phone along a line C-C illustrated in FIG. 1A; and
FIG. 13 is an enlarged view of the contact structure of the receiver and a display-side main substrate.

### DESCRIPTION OF EMBODIMENTS

Preferred embodiments will be explained with reference to accompanying drawings.

Incidentally, the present invention is not limited to this embodiment. For example, in the embodiment below, there is described a cellular phone as an example of the electronic device; however, the electronic device is not limited to this, and the embodiment can be applied to any other electronic devices, such as a smartphone, a personal computer (PC), and a personal digital assistant (PDA), as long as the electronic devices include a printed circuit board and an electrical component which is electrically connected to the printed circuit board. Furthermore, in the embodiment below, there are described a vibrator, a speaker, and a receiver as examples of electrical components of the cellular phone; however, the electrical components are not limited to these, and the present embodiment can be applied to any other electrical components which are electrically connected to the printed circuit board.

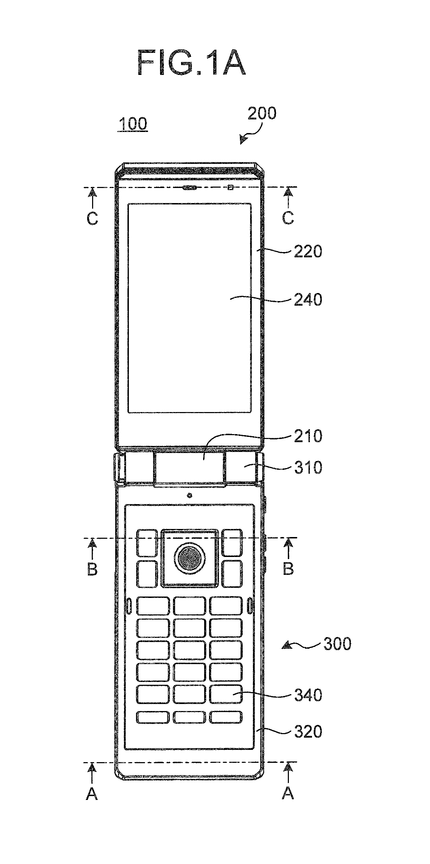

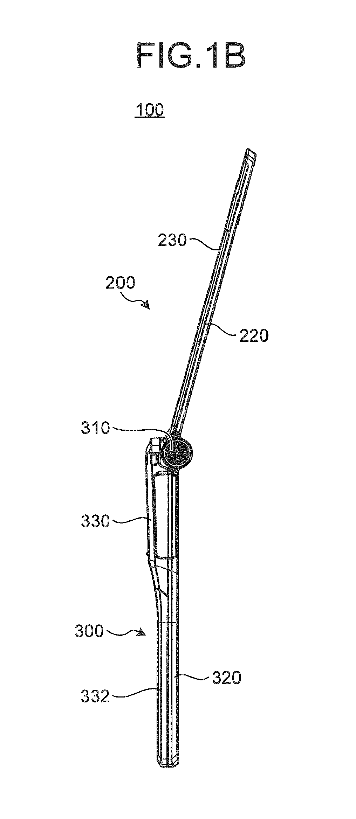

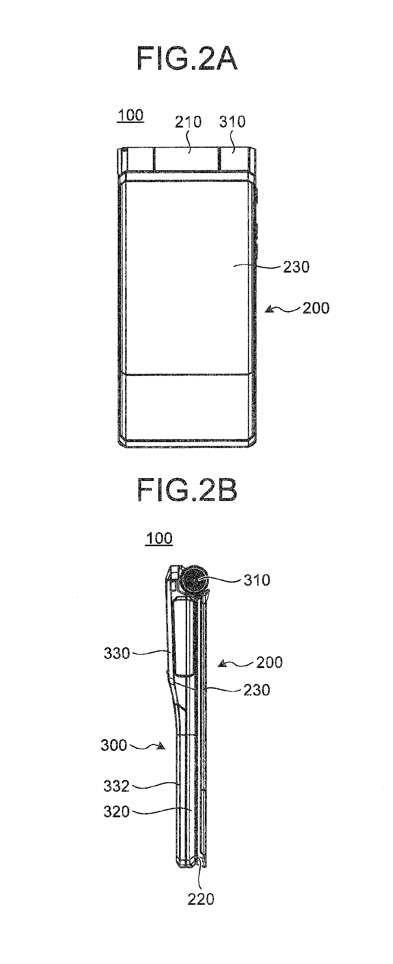

FIG. 1A is a front view of a cellular phone when it is in an open state; FIG. 1B is a side view of the cellular phone when it is in the open state. FIG. 2A is a front view of the cellular phone when it is in a folded state; FIG. 2B is a side view of the cellular phone when it is in the folded state.

As illustrated in FIGS. 1A, 1B, 2A, and 2B, a cellular phone 100 includes a display-side module 200 and an operation-side module 300. The display-side module 200 and the operation-side module 300 are connected via a hinge unit 210 forming a part of the display-side module 200 and a hinge unit 310 forming a part of the operation-side module 300 so that the cellular phone 100 can be folded.

The display-side module 200 includes a display-side front case 220 having an opening on one side thereof and a display-side rear case 230 having an opening on one side thereof. Furthermore, the display-side module 200 includes various components packed in a space formed by fitting the display-side front case 220 with the display-side rear case 230 so that the opening sides of them face each other. For example, an aperture is formed on a portion of the side opposite to the opening side of the display-side front case 220, and a display unit, such as a liquid crystal display (LCD) 240, is installed in the aperture portion.

The operation-side module 300 includes an operation-side front case 320 having an opening on one side thereof, an operation-side rear case 330 having an opening on one side thereof, and an operation-side rear cover 332 which is detachably fitted with the operation-side rear case 330 to cover a range of about half of the side opposite to the opening side of the operation-side rear case 330. Furthermore, the operation-side module 300 includes various components packed in a space formed by fitting the operation-side front case 320 with the operation-side rear case 330 so that the opening sides of them face each other. For example, a keytop 340 for performing various operations of the cellular phone 100 is installed on the side opposite to the opening side of the operation-side front case 320.

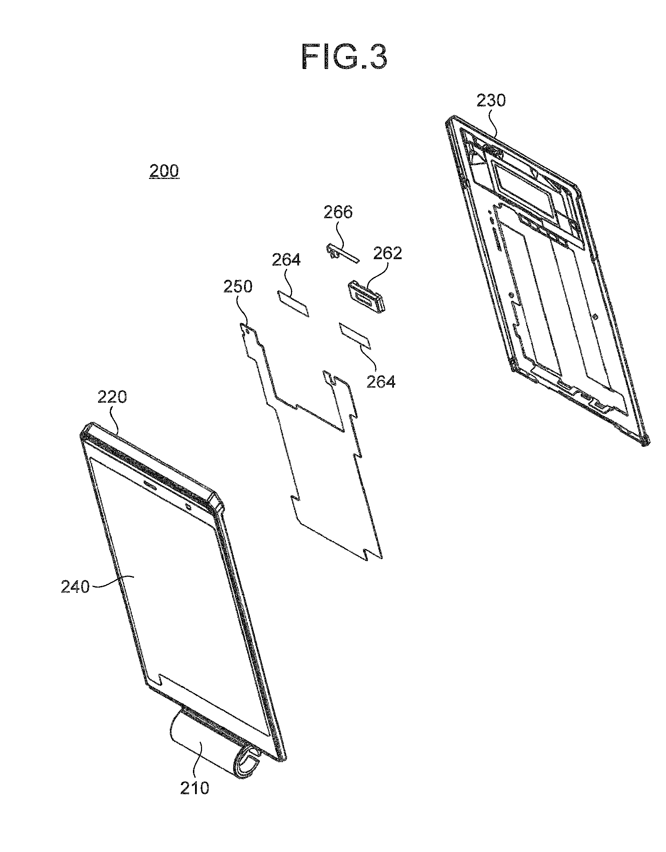

Subsequently, details of the display-side module 200 are explained. FIG. 3 is an exploded perspective view of the display-side module. As illustrated in FIG. 3, the display-side module 200 includes the LCD 240 and a display-side main substrate 250 in an internal space formed by the display-side front case 220 and the display-side rear case 230. Furthermore, the display-side module 200 includes a receiver 262, contact plates 264, and a global positioning system (GPS) antenna 266 in the internal space formed by the display-side front case 220 and the display-side rear case 230.

The LCD 240 is an output interface of the cellular phone 100, and is a liquid crystal panel on which various information and various screens are displayed. The GPS antenna 266 is an antenna for receiving a radio wave sent from a GPS satellite. The receiver 262 is a receiver that receives a radio signal received by the GPS antenna 266 and demodulates the received radio signal. The display-side main substrate 250 is a printed circuit board on which a wiring pattern for sending and receiving, for example, a radio signal received by the GPS antenna 266 with the receiver 262 is formed. The contact plates 264 are sheet metal plates used to send and receive a signal between the display-side main substrate 250 and the receiver 262. Details of the structures of the display-side main substrate 250, the receiver 262, the contact plates 264, and the like will be described later.

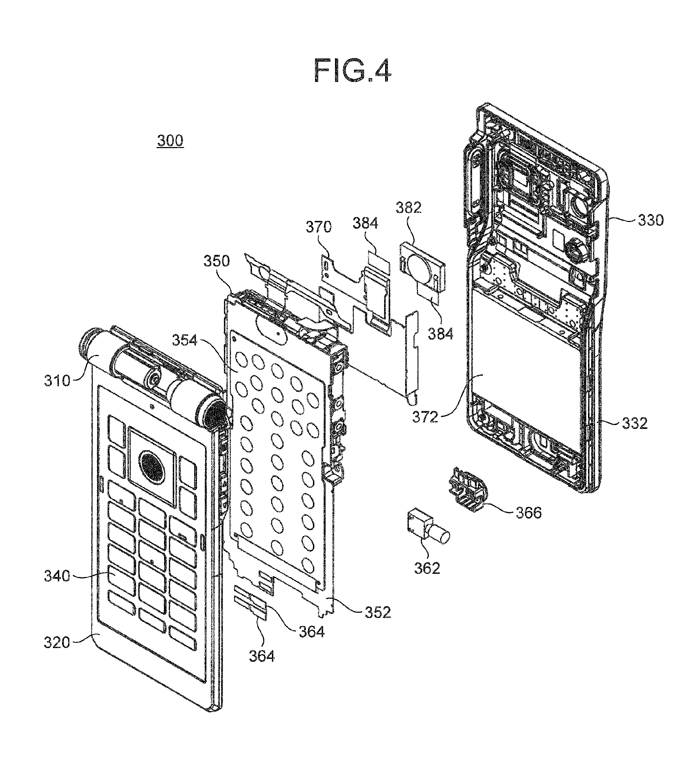

Subsequently, details of the operation-side module 300 are explained. FIG. 4 is an exploded perspective view of the operation-side module. As illustrated in FIG. 4, the operation-side module 300 includes an operation-side front substrate unit 350, a vibrator 362, contact plates 364, and a vibrator holder 366 in an internal space formed by the operation-side front case 320 and the operation-side rear case 330. Furthermore, the operation-side module 300 includes an operation-side rear substrate 370, a speaker 382, contact plates 384, and a battery 372 in the internal space formed by the operation-side front case 320 and the operation-side rear case 330. The operation-side rear cover 332 covers the range of about half of the side opposite to the opening side of the operation-side rear case 330 so that the battery 372 can be taken in and out from the outside, and is detachably fitted with the operation-side rear case 330.

The operation-side front substrate unit 350 includes an operation-side front substrate 352, a top tape 354 attached to the board surface of the operation-side front substrate 352, and the like. The operation-side front substrate 352 is a printed circuit board on which a wiring pattern for sending and receiving, for example, an operation signal associated with depression of the keytop 340 made by a user with another component is formed. The top tape 354 is an insulating sheet that covers metal domes acting as contacts for operations formed on the board surface of the operation-side front substrate 352.

The vibrator 362 is a vibrator installed to inform a user of an incoming call or an incoming mail, etc. The vibrator holder 366 is a container with a space in which the vibrator 362 is contained. The contact plates 364 are sheet metal plates used to send and receive a signal between the operation-side front substrate 352 and the vibrator 362. Details of the structures of the operation-side front substrate 352, the vibrator 362, the contact plates 364, and the like will be described later.

The operation-side rear substrate 370 is a printed circuit board on which a wiring pattern for sending and receiving, for example, a drive signal for driving the speaker 382 with the speaker 382 is formed. The speaker 382 is a speaker that outputs a sound in accordance with a drive signal sent from the operation-side rear substrate 370. The contact plates 384 are sheet metal plates used to send and receive a signal between the operation-side rear substrate 370 and the speaker 382. Details of the structures of the operation-side rear substrate 370, the speaker 382, the contact plates 384, and the like will be described later.

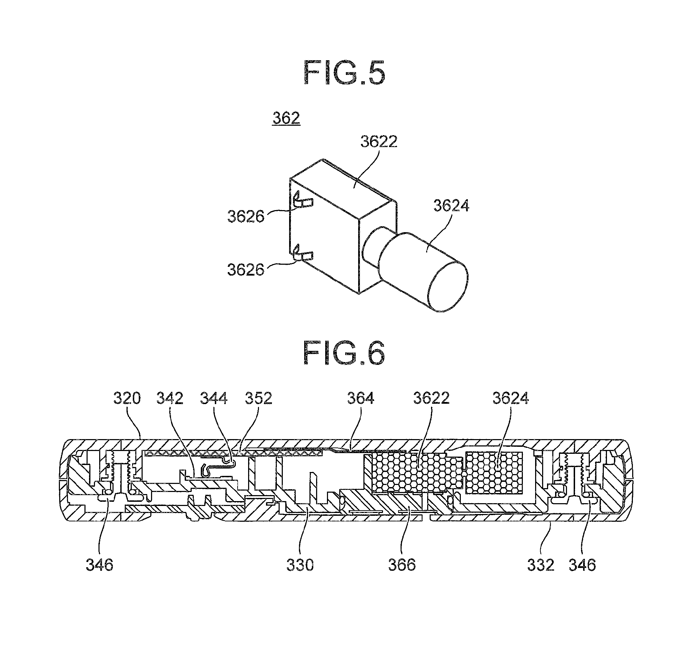

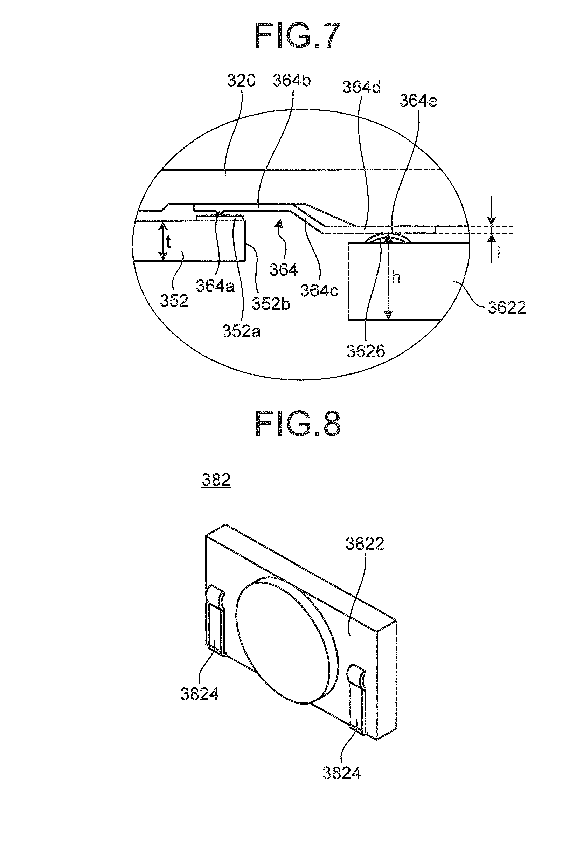

Subsequently, the structures of the operation-side front substrate 352, the vibrator 362, the contact plates 364, and the like are explained. FIG. 5 is a perspective view of the vibrator. FIG. 6 is a cross-sectional view of the cellular phone along a line A-A illustrated in FIG. 1A. FIG. 7 is an enlarged view of the contact structure of the vibrator and the operation-side front substrate. Incidentally, for convenience of explanation, components are schematically depicted in FIG. 7, so the actual dimensions of the components may be different.

First, as illustrated in FIG. 5, the vibrator 362 includes a body part 3622, a weight part 3624, and component contacts 3626 formed on the body part 3622. Inside the body part 3622, a motor for rotating the weight part 3624 is contained. The weight part 3624 is installed so that the center of gravity is biased toward the axis of the motor, and produces a vibration in accordance with rotation of the motor. The component contacts 3626 are electrical contacts for receiving a drive signal for driving the motor to produce a vibration from another component. The component contacts 3626 are, for example, belt-like sheet metal plates of which the one end is connected to the motor and the other end is arched, thereby having a spring property.

Subsequently, as illustrated in FIG. 6, the operation-side front case 320 and the operation-side rear case 330 are connected by screws 346. A 1-Seg antenna 342 is installed on the operation-side rear case 330, and a radio signal received by the 1-Seg antenna 342 is transmitted to the operation-side front substrate 352 via a contact spring 344.

Furthermore, as illustrated in FIGS. 6 and 7, a substrate contact 352a acting as a point of contact with another component (the vibrator) is formed on the board surface of the operation-side front substrate 352. The substrate contact 352a is, for example, a land where a conductive part of the wiring pattern formed on the operation-side front substrate 352 is exposed. The vibrator 362 is placed so that the body part 3622 and a part of the component contact 3626 are opposed to an end face 352b of the operation-side front substrate 352.

The contact plate 364 is a sheet metal plate formed to have a plate thickness (i) which is thinner than a board thickness (t) of the operation-side front substrate 352, and has a conductive property. The contact plate 364 extends from a first contact portion in contact with the substrate contact 352a to the outside of the external form of the operation-side front substrate 352 along the board surface of the operation-side front substrate 352, and a second contact portion in contact with the component contact 3626 is formed on the plate surface of the contact plate 364 on the outside of the external form of the operation-side front substrate 352.

More specifically, the contact plate 364 has a first contact portion 364a and a first extending portion 364b; the first contact portion 364a is in contact with the substrate contact 352a, and the first extending portion 364b extends from the first contact portion 364a to the outside of the external form of the operation-side front substrate 352 along the board surface of the operation-side front substrate 352. The first contact portion 364a is a projection formed on the plate surface of the first extending portion 364b. Furthermore, the contact plate 364 has a downslope portion 364c that extends from an end of the first extending portion 364b on the side of the outside of the external form of the operation-side front substrate 352 and slopes downward to the side of the reverse side of the board surface of the operation-side front substrate 352. Moreover, the contact plate 364 has a second extending portion 364d and a second contact portion 364e; the second extending portion 364d extends from the downslope portion 364c along an extending direction of the first extending portion 364b, and the second contact portion 364e is formed on the second extending portion 364d so that the second contact portion 364e is on the same side as the side on which the first contact portion 364a is formed.

In this manner, the vibrator 362 is placed so that the body part 3622 and a part of the component contact 3626 are opposed to the end face 352b of the operation-side front substrate 352, and is connected to the operation-side front substrate 352 via the contact plate 364. Therefore, according to the present embodiment, it is possible to achieve the thin cellular phone 100 having the operation-side front substrate 352 and an electrical component (the vibrator 362).

Namely, let's think of a case where the vibrator 362 is directly connected to the operation-side front substrate 352. In this case, when the board thickness of the operation-side front substrate 352 is denoted by (t), and the thickness of the vibrator 362 including the body part 3622 and the component contact 3626 is denoted by (h), the overall thickness of the vibrator 362 and the operation-side front substrate 352 is (t+h). On the other hand, in the present embodiment, when the plate thickness of the contact plate 364 is denoted by (i), the thickness of even the thickest portion is (i+h), i.e., the thickness of the vibrator 362 plus the thickness of the contact plate 364. Here, the plate thickness (i) of the contact plate 364 can be formed to be sufficiently thinner than the board thickness (t) of the operation-side front substrate 352 (i<<t). Therefore, the total thickness (i+h) of the vibrator 362 and the contact plate 364 in the present embodiment can be sufficiently thinner than the overall thickness (t+h) when the vibrator 362 is directly connected to the operation-side front substrate 352.

Furthermore, it is conceivable that the distantly-located vibrator 362 and the operation-side front substrate 352 are connected by a jumper wire. In this case, one end of the jumper wire is connected to the component contact 3626 of the vibrator 362 by manual soldering, and the other end of the jumper wire is connected to the substrate contact 352a of the operation-side front substrate 352 by manual soldering. Accordingly, the number of steps of the manufacturing process is increased due to the manual soldering, resulting in an increase in manufacturing cost, and in addition, the thickness of solder applied to a joint part in the manual soldering increases, for example, the thickness of the vibrator 362 due to the addition of the thickness of the soldered part. However, in the present embodiment, the plate thickness (i) of the contact plate 364 can be formed to be sufficiently thinner than the thickness of solder applied to the joint part in the manual soldering. Therefore, the total thickness of the vibrator 362 and the contact plate 364 in the present embodiment can be sufficiently thinner than the overall thickness when the vibrator 362 and the operation-side front substrate 352 are connected by the jumper wire. Incidentally, in the present embodiment, there is described an example where the contact plate 364 has the first extending portion 364b, the downslope portion 364c, and the second extending portion 364d; however, it is not limited to this, and the contact plate 364 can be an unbent, straight sheet metal plate.

Furthermore, the contact of the substrate contact 352a with the first contact portion 364a and the contact of the component contact 3626 with the second contact portion 364e are achieved, for example, by pressing the operation-side front substrate 352 and the vibrator 362 to the side of the operation-side front case 320. Alternatively, the contact of the substrate contact 352a with the first contact portion 364a and the contact of the component contact 3626 with the second contact portion 364e can be achieved, for example, by using a spring property of the contact plate 364. Much the same is true on the contact of the contact plates 384 with the operation-side rear substrate 370 and the speaker 382 and the contact of the contact plates 264 with the display-side main substrate 250 and the receiver 262.

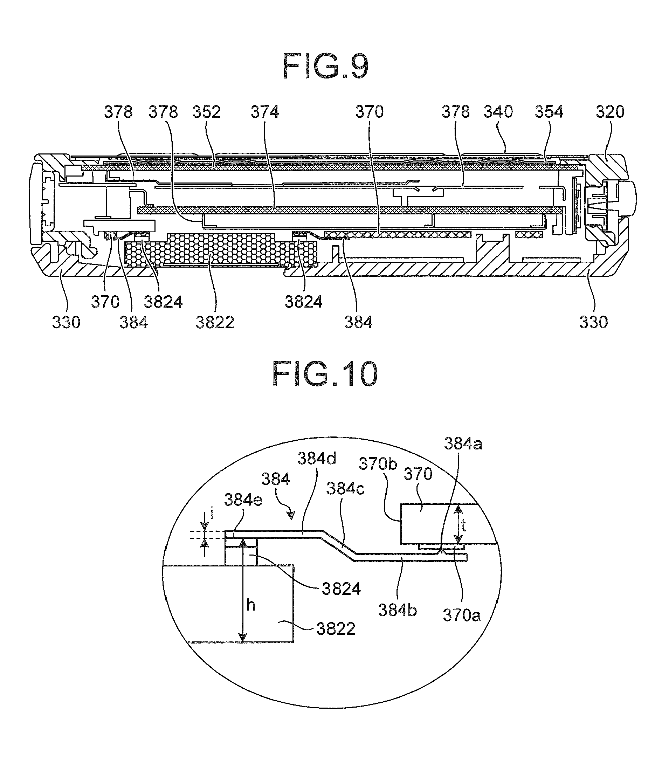

Subsequently, the structures of the operation-side rear substrate 370, the speaker 382, the contact plates 384, and the like are explained. FIG. 8 is a perspective view of the speaker. FIG. 9 is a cross-sectional view of the cellular phone along a line B-B illustrated in FIG. 1A. FIG. 10 is an enlarged view of the contact structure of the speaker and the operation-side rear substrate. Incidentally, for convenience of explanation, components are schematically depicted in FIG. 10, so the actual dimensions of the components may be different.

First, as illustrated in FIG. 8, the speaker 382 includes a body part 3822 and component contacts 3824 formed on the body part 3822. Inside the body part 3822, a diaphragm for output of a sound and an electronic component, such as a coil, for physically vibrating the diaphragm are contained. The component contacts 3824 are electrical contacts for receiving a drive signal for causing the diaphragm to physically vibrate to produce a sound from another component. The component contacts 3824 are, for example, belt-like sheet metal plates of which the one end is connected to the electronic component, such as a coil, and the other end is arched, thereby having a spring property.

Subsequently, as illustrated in FIG. 9, the top tape 354 is installed on the operation-side front substrate 352, and the keytop 340 is installed on top of the top tape 354. Furthermore, an operation-side main substrate 374 is installed between the operation-side front substrate 352 and the operation-side rear substrate 370. A shield sheet metal plate 378 is installed between the operation-side front substrate 352 and the operation-side main substrate 374, and shields the operation-side main substrate 374 from various noise signals such as a high-frequency noise. Furthermore, a shield sheet metal plate 378 is installed between the operation-side main substrate 374 and the operation-side rear substrate 370 as well, and shields the operation-side main substrate 374 from various noise signals such as a high-frequency noise.

Furthermore, as illustrated in FIGS. 9 and 10, a substrate contact 370a acting as a point of contact with another component (the speaker) is formed on the board surface of the operation-side rear substrate 370. The substrate contact 370a is, for example, a land where a conductive part of the wiring pattern formed on the operation-side rear substrate 370 is exposed. The speaker 382 is placed so that a part of the component contact 3824 is opposed to an end face 370b of the operation-side rear substrate 370.

The contact plate 384 is a sheet metal plate formed to have a plate thickness (i) which is thinner than a board thickness (t) of the operation-side rear substrate 370, and has a conductive property. The contact plate 384 extends from a first contact portion in contact with the substrate contact 370a to the outside of the external form of the operation-side rear substrate 370 along the board surface of the operation-side rear substrate 370, and a second contact portion in contact with the component contact 3824 is formed on the plate surface of the contact plate 384 on the outside of the external form of the operation-side rear substrate 370.

More specifically, the contact plate 384 has a first contact portion 384a and a first extending portion 384b; the first contact portion 384a is in contact with the substrate contact 370a, and the first extending portion 384b extends from the first contact portion 384a to the outside of the external form of the operation-side rear substrate 370 along the board surface of the operation-side rear substrate 370. The first contact portion 384a is a projection formed on the plate surface of the first extending portion 384b. Furthermore, the contact plate 384 has a downslope portion 384c that extends from an end of the first extending portion 384b on the side of the outside of the external form of the operation-side rear substrate 370 and slopes downward to the side of the reverse side of the board surface of the operation-side rear substrate 370. Moreover, the contact plate 384 has a second extending portion 384d and a second contact portion 384e; the second extending portion 384d extends from the downslope portion 384c along an extending direction of the first extending portion 384b, and the second contact portion 384e is formed on the second extending portion 384d so that the second contact portion 384e is on the side opposite to the side on which the first contact portion 384a is formed.

In this manner, the speaker 382 is placed so that a part of the component contact 3824 is opposed to the end face 370b of the operation-side rear substrate 370, and is connected to the operation-side rear substrate 370 via the contact plate 384. Therefore, according to the present embodiment, it is possible to achieve the thin cellular phone 100 having the operation-side rear substrate 370 and an electrical component (the speaker 382).

Namely, let's think of a case where the speaker 382 is directly connected to the operation-side rear substrate 370. In this case, when the board thickness of the operation-side rear substrate 370 is denoted by (t), and the thickness of the speaker 382 including the body part 3822 and the component contact 3824 is denoted by (h), the overall thickness of the speaker 382 and the operation-side rear substrate 370 is (t+h). On the other hand, in the present embodiment, when the plate thickness of the contact plate 384 is denoted by (i), the thickness of even the thickest portion is (i+h), i.e., the thickness of the speaker 382 plus the thickness of the contact plate 384. Here, the plate thickness (i) of the contact plate 384 can be formed to be sufficiently thinner than the board thickness (t) of the operation-side rear substrate 370 (i<<t). Therefore, the total thickness (i+h) of the speaker 382 and the contact plate 384 in the present embodiment can be sufficiently thinner than the overall thickness (t+h) when the speaker 382 is directly connected to the operation-side rear substrate 370.

Furthermore, it is conceivable that the distantly-located speaker 382 and the operation-side rear substrate 370 are connected by a jumper wire. In this case, one end of the jumper wire is connected to the component contact 3824 of the speaker 382 by manual soldering, and the other end of the jumper wire is connected to the substrate contact 370a of the operation-side rear substrate 370 by manual soldering. Accordingly, the number of steps of the manufacturing process is increased due to the manual soldering, resulting in an increase in manufacturing cost, and in addition, the thickness of solder applied to a joint part in the manual soldering increases, for example, the thickness of the speaker 382 due to the addition of the thickness of the soldered part. However, in the present embodiment, the plate thickness (i) of the contact plate 384 can be formed to be sufficiently thinner than the thickness of solder applied to the joint part in the manual soldering. Therefore, the total thickness of the speaker 382 and the contact plate 384 in the present embodiment can be sufficiently thinner than the overall thickness when the speaker 382 and the operation-side rear substrate 370 are connected by the jumper wire. Incidentally, in the present embodiment, there is described an example where the contact plate 384 has the first extending portion 384b, the downslope portion 384c, and the second extending portion 384d; however, it is not limited to this, and the contact plate 384 can be an unbent, straight sheet metal plate.

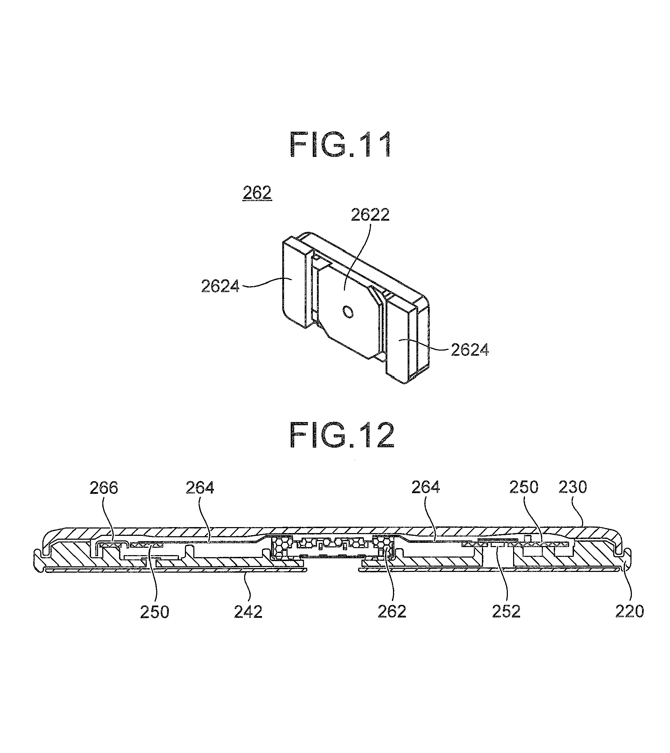

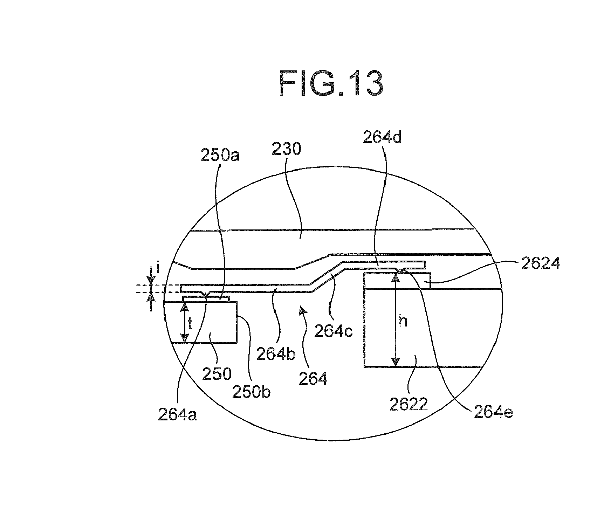

Subsequently, the structures of the display-side main substrate 250, the receiver 262, the contact plates 264, and the like are explained. FIG. 11 is a perspective view of the receiver. FIG. 12 is a cross-sectional view of the cellular phone along a line C-C illustrated in FIG. 1A. FIG. 13 is an enlarged view of the contact structure of the receiver and the display-side main substrate. Incidentally, for convenience of explanation, components are schematically depicted in FIG. 13, so the actual dimensions of the components may be different.

First, as illustrated in FIG. 12, the receiver 262 includes a body part 2622 and component contacts 2624 formed on the body part 2622. Inside the body part 2622, electronic components, such as a mixer and a wave detector, for receiving a radio signal received by the GPS antenna 266 and demodulating the received radio signal are contained. The component contacts 2624 are electrical contacts for receiving a radio signal received by the GPS antenna 266.

Subsequently, as illustrated in FIG. 12, a transparent LCD panel 242 for protecting the LCD 240 is installed in the display-side main substrate 250. Furthermore, to control the backlight brightness of the LCD 240 depending on the surrounding brightness, an illuminance sensor 252 that converts the surrounding brightness into an electric current is installed in the display-side main substrate 250. Moreover, the GPS antenna 266 is connected to the display-side main substrate 250, and a radio signal received by the GPS antenna 266 is transmitted to the display-side main substrate 250 and also transmitted to the receiver 262 via the contact plate 264.

Furthermore, as illustrated in FIGS. 12 and 13, a substrate contact 250a acting as a point of contact with another component (the receiver) is formed on the board surface of the display-side main substrate 250. The substrate contact 250a is, for example, a land where a conductive part of the wiring pattern formed on the display-side main substrate 250 is exposed. The receiver 262 is placed so that a part of the body part 2622 is opposed to an end face 250b of the display-side main substrate 250.

The contact plate 264 is a sheet metal plate formed to have a plate thickness (i) which is thinner than a board thickness (t) of the display-side main substrate 250, and has a conductive property. The contact plate 264 extends from a first contact portion in contact with the substrate contact 250a to the outside of the external form of the display-side main substrate 250 along the board surface of the display-side main substrate 250, and a second contact portion in contact with the component contact 2624 is formed on the plate surface of the contact plate 264 on the outside of the external form of the display-side main substrate 250.

More specifically, the contact plate 264 has a first contact portion 264a and a first extending portion 264b; the first contact portion 264a is in contact with the substrate contact 250a, and the first extending portion 264b extends from the first contact portion 264a to the outside of the external form of the display-side main substrate 250 along the board surface of the display-side main substrate 250. The first contact portion 264a is a projection formed on the plate surface of the first extending portion 264b. Furthermore, the contact plate 264 has an upslope portion 264c that extends from an end of the first extending portion 264b on the side of the outside of the external form of the display-side main substrate 250 and slopes upward in a direction away from the board surface of the display-side main substrate 250. Moreover, the contact plate 264 has a second extending portion 264d and a second contact portion 264e; the second extending portion 264d extends from the upslope portion 264c along an extending direction of the first extending portion 264b, and the second contact portion 264e is formed on the second extending portion 264d so as to be located on the same side as the side on which the first contact portion 264a is formed. The second contact portion 264e is a projection formed on the plate surface of the second extending portion 264d.

In this manner, the receiver 262 is placed so that a part of the body part 2622 is opposed to the end face 250b of the display-side main substrate 250, and is connected to the display-side main substrate 250 via the contact plate 264. Therefore, according to the present embodiment, it is possible to achieve the thin cellular phone 100 having the display-side main substrate 250 and an electrical component (the receiver 262).

Namely, let's think of a case where the receiver 262 is directly connected to the display-side main substrate 250. In this case, when the board thickness of the display-side main substrate 250 is denoted by (t), and the thickness of the receiver 262 including the body part 2622 and the component contact 2624 is denoted by (h), the overall thickness of the receiver 262 and the display-side main substrate 250 is (t+h). On the other hand, in the present embodiment, when the plate thickness of the contact plate 264 is denoted by (i), the thickness of even the thickest portion is (i+h), i.e., the thickness of the receiver 262 plus the thickness of the contact plate 264. Here, the plate thickness (i) of the contact plate 264 can be formed to be sufficiently thinner than the board thickness (t) of the display-side main substrate 250 (i<<t). Therefore, the total thickness (i+h) of the receiver 262 and the contact plate 264 in the present embodiment can be sufficiently thinner than the overall thickness (t+h) when the receiver 262 is directly connected to the display-side main substrate 250.

Furthermore, it is conceivable that the distantly-located receiver 262 and the display-side main substrate 250 are connected by a jumper wire. In this case, one end of the jumper wire is connected to the component contact 2624 of the receiver 262 by manual soldering, and the other end of the jumper wire is connected to the substrate contact 250a of the display-side main substrate 250 by manual soldering. Accordingly, the number of steps of the manufacturing process is increased due to the manual soldering, resulting in an increase in manufacturing cost, and in addition, the thickness of solder applied to a joint part in the manual soldering increases, for example, the thickness of the receiver 262 due to the addition of the thickness of the soldered part. However, in the present embodiment, the plate thickness (i) of the contact plate 264 can be formed to be sufficiently thinner than the thickness of solder applied to the joint part in the manual soldering. Therefore, the total thickness of the receiver 262 and the contact plate 264 in the present embodiment can be sufficiently thinner than the overall thickness when the receiver 262 and the display-side main substrate 250 are connected by the jumper wire. Incidentally, in the present embodiment, there is described an example where the contact plate 264 has the first extending portion 264b, the upslope portion 264c, and the second extending portion 264d; however, it is not limited to this, and the contact plate 264 can be an unbent, straight sheet metal plate.

According to an aspect of an electronic device described in the present application, it is possible to achieve a thin electronic device having a printed circuit board and electrical components.

## Claims

1. An electronic device (100) comprising:
a printed circuit board (250,352,370) that a substrate contact part (250a,352a,370a) acting as a point of contact with another component (262,362,382) is formed on a board surface thereof;
a conductive member (264,364,384) that has a first contact portion (264a,364a,384a) in contact with the substrate contact part (250a,352a,370a), a plate-like extending portion (264b-d,364b-d,384b-d) extending from the first contact portion (264a,364a,384a) to the outside of external form of the printed circuit board (250,352,370) along the board surface of the printed circuit board(250,352,370), and a second contact portion (264e,354e,384e) formed on a plate surface of the extending portion (264b-d,364b-d,384b-d) on the outside of the external form of the printed circuit board (250,352,370); and
an electrical component (262,362,382) that includes a component contact part (2624,3626,3824) in contact with the second contact portion (264e,354e,384e) and a body part (2622,3622,3822) on which the component contact part (2624,3626,3824) is formed, and is placed such that the component contact part (2624,3626,3824) or at least a part of the body part (2622,3622,3822) is opposed to an end face (250b,352b,370b) of the printed circuit board (250,352,370).

2. The electronic device (100) according to claim 1, wherein the conductive member (264,364,384) is sheet metal plate formed to be thinner than a board thickness of the printed circuit board (250,352,370).
